# EUROPÄISCHE PATENTANMELDUNG

(11) **EP 1 681 261 A1**
(43) Veröffentlichungstag der Anmeldung: **19.07.2006**
(21) Anmeldenummer: 05017325.1
(22) Anmeldetag: 09.08.2005
(51) Int. Cl.: B66C 11/00

(54) **Vorrichtung zum Austausch und Transport von Komponenten von Beschichtungsanlagen**

(30) Priorität: 03.09.2004 DE 102004042776
(71) Anmelder: Applied Films GmbH & Co. KG, 63755 Alzenau (DE)
(72) Erfinder: Hattendorf, Guido, 63636 Brachttal (DE)
(74) Vertreter: GROSSE BOCKHORNI SCHUMACHER

(57) **Zusammenfassung**

Die vorliegende Erfindung betrifft eine Beschichtungsanlage (1), insbesondere Vakuumbeschichtungsanlage zur kontinuierlichen Beschichtung von großformatigen, scheiben- oder plattenförmigen Substraten, vorzugsweise Glassubstraten sowie eine Vorrichtung hierfür zum Austausch von Komponenten (10) der Beschichtungsanlage mit einem Transportsystem aus Transportweg (4) und mindestens einem entlang des Transportwegs verfahrbaren Wagen (6), an dem mindestens eine Hebeeinrichtung (7) zum Aufnehmen der auszutauschen Komponenten vorgesehen ist, wobei der Transportweg Führungsorgane aufweist, die einen genau vorgegebenen, der Beschichtungsanlage (1) zugeordneten Transportweg (4) definieren, wobei der Transportweg entlang der Beschichtungsanlage so angeordnet ist, dass der entlang des Transportwegs (4) verfahrbare Wagen (4) mit der Hebeeinrichtung (7) diese automatisch genau in die für die zu tauschenden Komponenten (10) richtige Hebe- und Absetzpositionen bringt.

## Beschreibung

Die vorliegende Erfindung betrifft eine Vorrichtung zum Austausch und Transport von Komponenten von Beschichtungsanlagen nach dem Oberbegriff des Anspruchs 1 bzw. eine Beschichtungsanlage nach dem Oberbegriff des Anspruchs 11.

Aus dem Stand der Technik sind Beschichtungsanlagen, insbesondere Vakuumbehandlungsanlagen für großformatige, scheiben- oder plattenförmige Substrate, wie z. B. Architekturverglasungen, die in einer kontinuierlichen Weise die Beschichtungsanlagen durchlaufen, um beispielsweise mit Wärmeschutzschichten oder dgl. versehen zu werden, bekannt. Derartige Anlagen sind oft aus einer Vielzahl von hintereinander angeordneten Kammern aufgebaut, um vielfältige Bearbeitungs- und Beschichtungsprozesse nacheinander ausführen zu können.

Bei derartigen Beschichtungsanlagen weisen beispielsweise die nebeneinander angeordneten Kammern an ihrer Oberseite Öffnungen auf, die durch sog. Kammerdeckel vakuumdicht verschlossen werden, wobei an den Kammerdeckeln entsprechende Prozesswerkzeuge, wie Kathoden und Pumpen, beispielsweise Turbomolekularpumpen oder Öldiffusionspumpen angeordnet sind. Eine derartige Anlage ist beispielsweise in der europäischen Patentanmeldung EP 4 007 253 beschrieben, wobei deren Offenbarung durch Verweis hier voll umfänglich mitaufgenommen wird.

Durch die Gestaltung der Kammern mit Kammerdeckeln und die Anordnung von Prozesswerkzeugen an den Kammerdeckeln ist ein einfacher Austausch der Prozesswerkzeuge bzw. ein einfacher Zugang zu den Kammern möglich, indem einfach die Kammerdeckel angehoben und entfernt bzw. ausgetauscht werden.

Hierzu wird üblicherweise nach dem Stand der Technik ein Hallenkran verwendet, der üblicherweise aus einem Wagen besteht, der an zwei an der Decke angeordneten Schienen über der Halle verfahrbar ist. Um eine möglichst große Abdeckung bezüglich des Zugangs mit dem Hallenkran zu erreichen, ist die Hebeeinrichtung zusätzlich an dem Wagen verfahrbar ausgestaltet, so dass senkrecht zur Bewegungsrichtung des Kranwagens eine Bewegung der Hebeeinrichtung, beispielsweise eines Flaschenzugs möglich ist. Damit kann, wenn die Schienen für den Kranwagen an den Seiten der Halle angeordnet sind, üblicherweise die gesamte Halle durch den Kran erreicht werden.

Entsprechend ist die übliche Vorgehensweise beim Austausch von Komponenten der Beschichtungsanlage, wie z. B. der Kammerdeckel derart, dass die neu einzubauenden Komponenten neben der Beschichtungsanlage in der Halle abgelegt, mittels des Krans die auszutauschenden Komponenten aus der Anlage ausgebaut und anschließend die neu einzubauenden Komponenten mittels des Krans in die Glasbeschichtungsanlage eingebaut werden. Hierzu sind mindestens zwei Personen notwendig, von denen eine den Kran manuell bedient, während die andere die von dem Kran frei herabhängende Komponente durch Halten stabilisiert. Außerdem müssen durch die zwei Personen die Befestigungsmittel des Krans an den alten und neuen Komponenten befestigt und gelöst werden.

Insgesamt ist dieses Verfahren bezüglich des Personal- und Zeitbedarfs sehr aufwändig.

Es ist deshalb Aufgabe der vorliegenden Erfindung diese Nachteile zu beseitigen und eine Lösung bereitzustellen, die ein einfaches und effektives Austauschen von Komponenten von Beschichtungsanlagen, insbesondere von kontinuierlich arbeitenden Glasbeschichtungsanlagen ermöglicht. Insbesondere ist es Aufgabe der vorliegenden Erfindung eine entsprechende Vorrichtung bzw. eine Beschichtungsanlage mit einer entsprechenden Vorrichtung bereitzustellen.

Diese Aufgabe wird gelöst durch eine Vorrichtung mit den Merkmalen des Anspruchs 1 bzw. eine Beschichtungsanlage mit den Merkmalen des Anspruchs 11. Vorteilhafte Ausgestaltungen sind Gegenstand der abhängigen Ansprüche.

Zur Lösung der oben genannten Aufgabe wird vorgeschlagen, statt eines variabel und flexibel zu bedienenden Hallenkrans ein speziell auf die Beschichtungsanlage angepasstes und zugeschnittenes Transportsystem zu installieren, welches zwar in der Flexibilität seiner Verwendung eingeschränkt, aber bei der Verwendung für den Austausch und den Transport von Komponenten der Beschichtungsanlage viel effektiver einzusetzen ist, so dass der zusätzliche Aufwand für ein derartiges Transportsystem gerechtfertigt ist. Entsprechend ist ein genau definierter, der Beschichtungsanlage zugeordneter Transportweg vorgesehen, auf dem mindestens ein verfahrbarer Wagen angeordnet ist, an welchem wiederum mindestens eine Hebeeinrichtung zur Aufnahme der auszutauschenden Komponenten angeordnet ist. Durch die genau auf die Beschichtungsanlage angepasste Gestaltung des Transportwegs ist es möglich, den verfahrbaren Wagen genau in die richtigen Hebe- und Absetzpositionen zu bringen und zwar ohne großen Aufwand. Vielmehr ist durch die vorgeschlagene Lösung gewährleistet, dass die an dem verfahrbaren Wagen vorgesehene Hebeeinrichtung automatisch, also zwangsgeführt in der richtigen Position über den aufzunehmenden Komponenten ist, und zwar zumindest in einer von zwei Dimensionen.

Bezüglich der zweiten Dimension kann der Wagen entsprechend durch einen Bediener verfahren werden oder ein computergesteuertes Positionierungssystem wird eingesetzt, bei welchem lediglich durch Angabe der auszutauschenden Komponente in der Beschichtungsanlage das System den Wagen automatisch in die richtige Position bringt. Hierzu sind lediglich entsprechende Sensoren am verfahrbaren Wagen und/oder am Transportweg sowie entsprechende Auswerteeinheiten erforderlich.

Mit einem derartigen System kann beispielsweise ein halbautomatischer Austausch von Komponenten realisiert werden, wobei dann lediglich noch die Befestigung der Hebeeinrichtung an den auszutauschenden oder aufzunehmenden Komponenten bzw. das Anheben und Absetzen manuell ausgelöst und/oder durchgeführt werden muss.

Vorzugsweise ist die Vorrichtung jedoch so ausgestaltet, dass ein vollautomatischer Austausch der Komponenten erfolgen kann. Dies ist beispielsweise in einfacher Weise dadurch möglich, dass die Befestigungsmittel der Hebeeinrichtung bzw. Hebeeinrichtungen und die Mittel zum Eingreifen der Hebeeinrichtungen bzw. der Befestigungsmittel an den Komponenten so aufeinander abgestimmt sind, dass ein automatisches Ergreifen und Loslassen der Komponenten möglich ist. Beispielsweise kann dies in einfacher Weise dadurch realisiert werden, dass drehbare Greifer vorgesehen sind, die durch Drehung zur Aufnahme in Hinterschneidungen an den aufzunehmenden Komponenten eingreifen oder zum Lösen an diesen vorbeigeführt werden können.

Vorzugsweise sind nach einer bevorzugten Ausführungsform an dem verfahrbaren Wagen mehrere Hebeeinrichtungen vorgesehen, so dass gleichzeitig mehrere Komponenten, wie z. B. Kammerdeckel, ausgetauscht werden können. Neben der Aufnahme und dem Transport von mehreren Komponenten zur gleichen Zeit hat dies oft den Vorteil, dass gleichzeitig die auszutauschende und die neue Komponente aufgenommen werden können, was Fahrwege und -zeiten für den verfahrbaren Wagen einspart.

Vorzugsweise sind die den Transportweg definierenden Führungsorgane, beispielsweise in Form von Schienen, über die gesamte Beschichtungsanlage, also über die gesamte Anlagenlänge vorgesehen, so dass überall ein Austausch von Komponenten erfolgen kann.

Vorzugsweise ist die Vorrichtung zum Austauschen und zum Transport von Komponenten auch in Bereichen der Beschichtungsanlage vorgesehen, in der üblicherweise keine Komponenten zum Austausch vorgesehen sind, wie z. B. im Einschleus-, Ausschleusbereich oder in Pufferbereichen. Diese Bereiche können dann in vorteilhafter Weise als Ablage- und/oder Aufnahmebereiche zur Bereitstellung und/oder Lagerung von Komponenten (neuen oder auszutauschenden) verwendet werden, so dass keine seitliche Lagerung neben der Beschichtungsanlage erforderlich ist. Dies hat eine große Platzersparnis als vorteilhafte Folge.

Hierbei ist es ferner vorteilhaft, wenn Ablage- und/oder Aufnahmebereich sowie Wagen und Hebeeinrichtung derart ausgestaltet sind, dass ein Stapeln der Komponenten, beispielsweise in einem Regal, möglich ist.

Vorzugsweise ist das Transportsystem bzw. der Fahrweg mit den Führungsorganen auf, benachbart zur Beschichtungsanlage oder oberhalb der Beschichtungsanlage angeordnet, wobei die vorzugsweise als Führungsorgane vorgesehenen Schienen auf der Beschichtungsanlage, am Boden oder an der Hallendecke angeordnet sein können.

Neben Schienen sind als Führungsorgane auch andere geeignete Arten von Führungen, wie z. B. Rundführungen, Magnetbahnen, Zahnstangen usw. mit entsprechend daran angepassten Bewegungsmitteln, wie Schlitten, Zahnrädern und dgl. denkbar. Auch alle geeigneten Antriebsmittel sind hier vorstellbar.

Ferner ist bei einer bevorzugten Ausführungsform ein Aufenthaltsbereich oder Leitstand für Menschen auf dem Wagen vorgesehen, um den Transport zu überwachen oder die Bedienung ortsnah vornehmen zu können.

Weitere Vorteile, Kennzeichen und Merkmale der vorliegenden Erfindung werden bei der nachfolgenden detaillierten Beschreibung von zwei Ausführungsbeispielen anhand der beigefügten Zeichnungen deutlich. Die rein schematischen Zeichnungen zeigen hierbei in
- Fig. 1: eine perspektivische Ansicht einer Glasbeschichtungsanlage mit einer erfindungsgemäßen Vorrichtung bei der Aufnahme von Kammerdeckeln im Beschichtungsbereich;
- Fig. 2: die Glasbeschichtungsanlage aus Fig. 1 mit der erfindungsgemäßen Vorrichtung bei der Ablage der Kammerdeckel im Ablage-/Aufnahmebereich;
- Fig. 3: eine zweite Ausführungsform der erfindungsgemäßen Vorrichtung an einer Glasbeschichtungsanlage;
- Fig. 4: die zweite Ausführungsform gemäß Fig. 3 in einer ersten Betriebsstellung; und in
- Fig. 5: die zweite Ausführungsform gemäß Fig. 3 in einer zweiten Betriebsstellung.

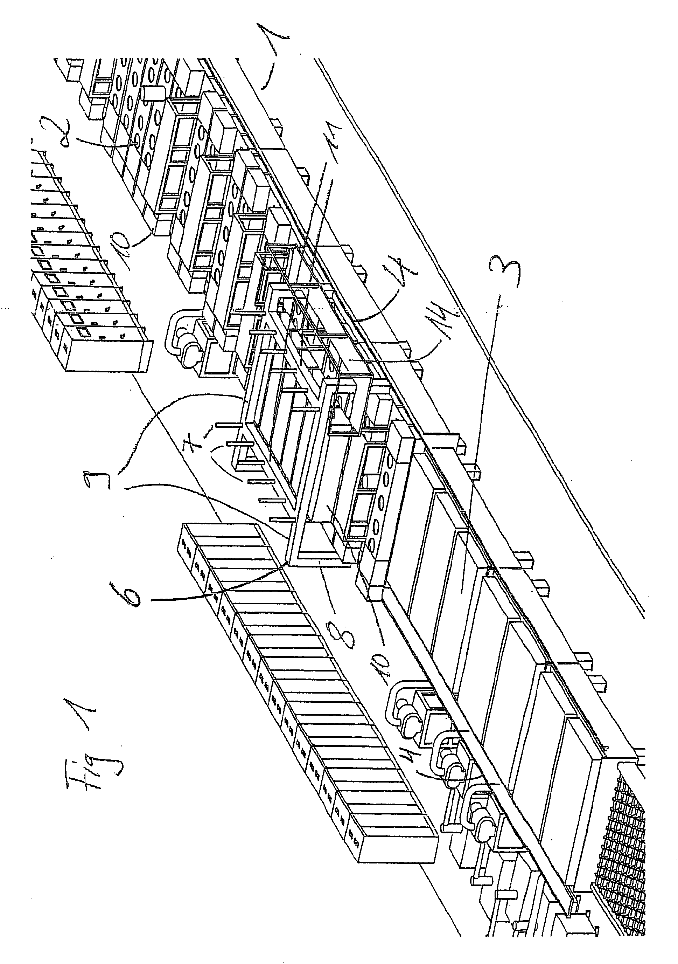

Die Fig. 1 zeigt in einer perspektivischen Ansicht eine Glasbeschichtungsanlage 1 mit einem Einschleusbereich 3 und einem Beschichtungsbereich 2, in denen jeweils mehrere sog. Kompartments nebeneinander angeordnet sind, durch die die Substrate, nämlich die Glasscheiben, während der Beschichtung hindurchgeführt werden. Während im Einschleusbereich 3 die verschiedenen Kammern (Kompartments) als Schleusen dienen, um die Glasscheiben diskontinuierlich in den Beschichtungsbereich 2 mit den Vakuumbedingungen einzuführen, werden in den nachfolgenden Kammern diese als Pumpkompartments bzw. Pumpstufen und/oder als Beschichtungskammern verwendet, wobei insbesondere in den einzelnen kontinuierlich durchlaufenen Beschichtungskammern unterschiedliche Schichten aufgebracht werden, so dass üblicherweise auf dem Glassubstrat eine Abfolge von verschiedenen oder gleichartigen Schichten abgeschieden werden kann.

Im Beschichtungsbereich 2 sind die einzelnen Kammern oben mit Öffnungen versehen, die durch einen Kammerdeckel 10 vakuumdicht verschlossen werden. An den Kammerdeckeln 10 sind vorzugsweise verschiedene Komponenten der Beschichtungsanlage, wie Pumpen, beispielsweise Turbomolekularpumpen oder Diffusionspumpen, sowie Kathoden und entsprechende Blendenanordnungen (nicht gezeigt) vorgesehen, die zusammen mit dem Kammerdeckel 10 an der Beschichtungskammer in einfacher Weise angeordnet bzw. in diese eingeführt werden können.

Bei dem gezeigten Ausführungsbeispiel der Fig. 1 ist an der Oberseite der Glasbeschichtungsanlage, die aus den nebeneinander angeordneten Kammern aufgebaut ist, ein Transportweg in Form von Schienen 4 vorgesehen, und zwar jeweils eine Schiene an den gegenüberliegenden Längsseiten der Glasbeschichtungsanlage 1, sowie ein auf den Schienen 4 verfahrbarer Wagen 6. Der Wagen 6 besteht aus zwei parallel und beabstandet angeordneten Trägern 9, die über ebenfalls parallel und beabstandet angeordnete Querträger 11, welche parallel zur Durchlaufrichtung der Glassubstrate angeordnet sind, miteinander verbunden sind. Dieses Gestell aus Träger 9 und Querträger 11 weist an den Enden der Träger 9 jeweils eine vertikale Stütze 8 auf, an der an der Unterseite Rollen oder Räder angeordnet sind, die zumindest an zwei der Stützen 8 über ihnen zugeordnete Elektromotoren (nicht gezeigt) angetrieben werden. Die Räder sind an den Schienen 4 angeordnet, so dass durch den Antrieb mittels der Elektromotoren der Wagen 6 entlang der Glasbeschichtungsanlage 1 verfahren werden kann. Neben Rädern sind auch andere Bewegungsmittel wie Kufen oder dgl. denkbar.

An dem Wagen 6 sind Hub- bzw. Hebeeinrichtungen 7 vorgesehen, mittels der die Kammerdeckel 10 ergriffen und angehoben sowie an entsprechenden Stellen wieder abgesetzt und losgelassen werden können.

Am Wagen 6 ist ferner ein Standbereich 14 vorgesehen, auf dem das Bedienungspersonal mitfahren kann, um die Vorgänge zu überwachen oder beispielsweise die Hebeeinrichtungen zu befestigen oder zu lösen. Vorzugsweise kann der Standbereich 14 als Leitstand ausgebildet sein, von dem aus alle Vorgänge gesteuert werden können.

Durch die Zuordnung der Schienen 4 bzw. des Transportwegs des Wagens 6 zu der Glasbeschichtungsanlage und der Abstimmung der Hebeeinrichtungen 7 auf die anzuhebenden Kammerdeckel 10 ist eine vollautomatische Auswechslung eines Kammerdeckels 10 beispielsweise zum Kathodenwechsel, möglich. Zu diesem Zweck wird der Wagen 6 in dem Beschichtungsbereich 2 verfahren, und zwar an eine Stelle, an der der zu wechselnde Kammerdeckel 10 mit der zu wechselnden Kathode durch die Hebeeinrichtungen 7 ergriffen und angehoben werden kann. Der so aufgenommene Kammerdeckel 10 wird dann so weit angehoben, dass ein weiteres Verfahren des Wagens 6 entlang des Transportweges 4 bzw. Schienen 4 möglich ist.

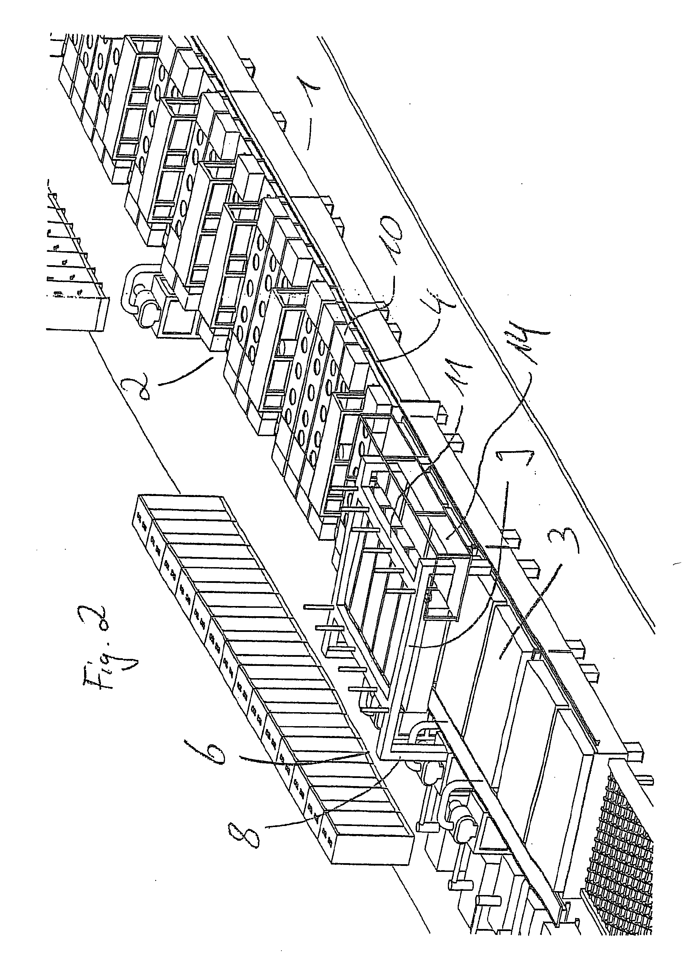

Wie in Fig. 2 zu erkennen ist, ist ein Ablege-/Aufnahmebereich oberhalb des Schleusenbereichs 3 vorgesehen, in dem beispielsweise keine auswechselbaren Komponenten, wie Kammerdeckel, vorhanden sind. Darüber hinaus könnte ein Ablege-/Aufnahmebereich auch variabel in den Bereichen der Anlage gebildet werden, in denen vorübergehend kein Austausch erforderlich ist.

In dem Aufnahme-/Ablagebereich des Schleusenbereichs 3 wird der entnommene Kammerdeckel 10 abgelegt und möglicherweise ein für den Einbau dort vorbereiteter Kammerdeckel 10 aufgenommen und an die entsprechende Stelle der Beschichtungsanlage zum Einbau transportiert.

Um gleichzeitig mehrere auszutauschende Komponenten, wie z. B. Kammerdeckel 10, aufnehmen zu können, kann der Wagen 6 in seinen Dimensionen so gestaltet sein, dass mehrere Kammerdeckel gleichzeitig nebeneinander aufgenommen werden können. Entsprechend sind ausreichend viele Hebeeinrichtungen 7 vorzusehen. Bei einer derartigen Ausgestaltung können nicht nur gleichzeitig mehrere nebeneinander liegende Kammerdeckel entfernt oder eingebaut werden, sondern es kann während des Ein- und Ausbaus gleichzeitig der auszubauende und der neu einzubauende Kammerdeckel 10 in dem Wagen 6 gehalten werden, so dass ein zusätzliches Verfahren des Wagens 6 entbehrlich wird und die Einbauzeit sich stark verkürzt.

Entsprechend ist es auch möglich, mehrere Wagen 6 an einer Glasbeschichtungsanlage 1 bzw. dem dort vorgesehenen Transportsystem aus Transportweg 4 und verfahrbaren Wagen 6 zu installieren, um gleichzeitig an mehreren Stellen einen Austausch von Komponenten vornehmen zu können.

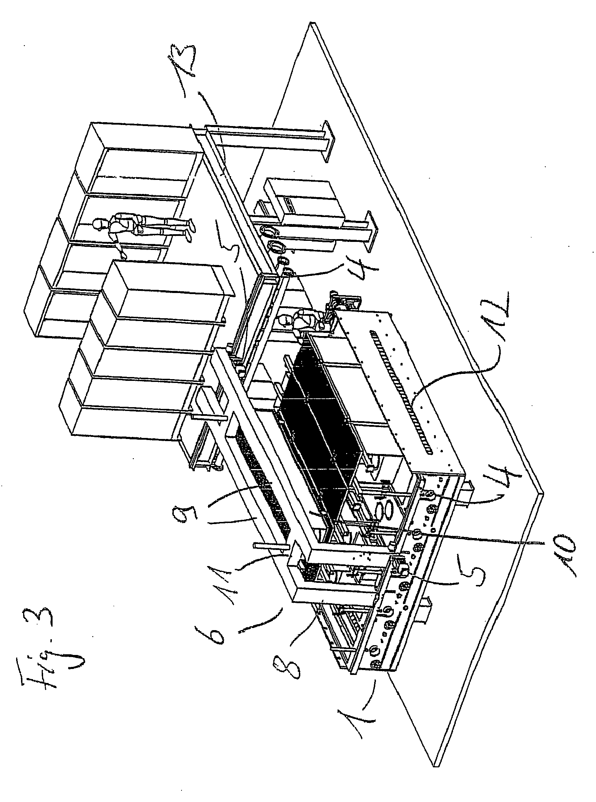

Ein weiteres Ausführungsbeispiel ist in der Fig. 3 dargestellt, wobei hier vergleichbare Bauteile mit identischen Bezugszeichen versehen sind, so dass eine detaillierte Erläuterung dieser Bauteile sich erübrigt. Wie aus der perspektivischen Darstellung der Fig. 3 zu ersehen ist, handelt es sich bei der Beschichtungsanlage der Fig. 3, bei der nur der Beschichtungsbereich dargestellt ist, um einen ähnlichen Aufbau einer Glasbeschichtungsanlage 1, an der weitere Kammern, z.B. Prozess- und Transferkammern, angeordnet werden können. Der Transportwagen 6 sowie die Anordnung der Schienen 4 weisen hier eine kompaktere Bauweise auf.

Während eine der Schienen 4 wie bei dem vorangegangenen Ausführungsbeispiel an einer Seite der Glasbeschichtungsanlage 1 an der Oberseite angeordnet ist, ist die andere Schiene 4 auf einer neben der Glasbeschichtungsanlage 1 vorgesehenen Plattform 13, auf der die Steuerungselektronik untergebracht ist, vorgesehen. Entsprechend entfallen bei dieser Bauweise beim Wagen 6 an der einen Seite die Stützen 8, so dass sich für die Träger mit Stützen entgegen der U-Form für das Ausführungsbeispiel der Fig. 1 und 2 eine L-Form ergibt. Die Räder bzw. Rollen zur Führung des Wagens 6 sind somit bei dem Ausführungsbeispiel der Fig. 3 einerseits an den Stützen 8 und andererseits direkt an den Trägern 9 vorgesehen. Auch hier sind den Rädern bzw. Rollen Antriebsmittel in Form von direkt zugeordneten Elektromotoren 5 zumindest an einem der Träger 9 zugeordnet. In dem Ausführungsbeispiel der Fig. 3 sieht man auch die Transportebene 12 für das zu beschichtende Substrat.

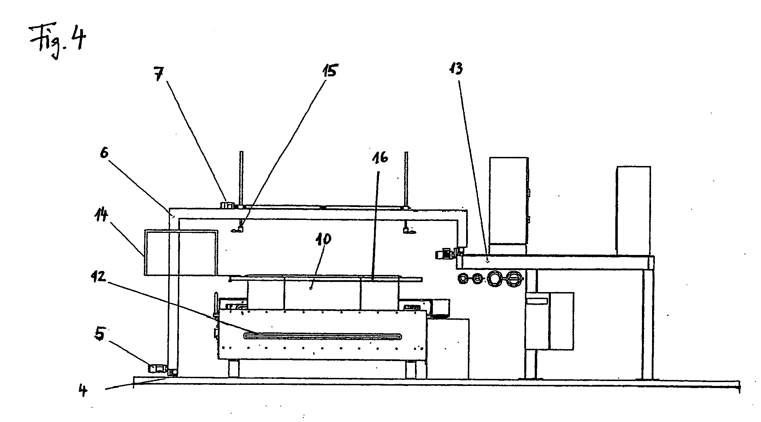

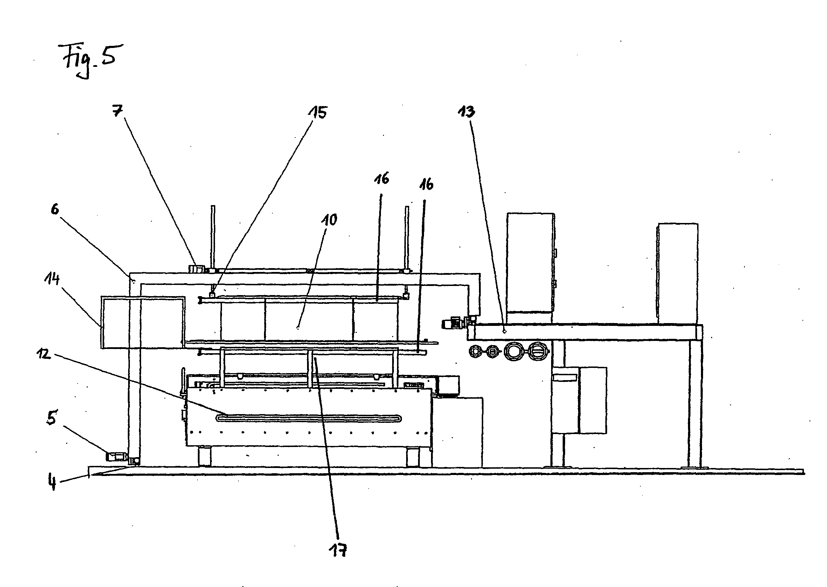

In den Fig. 4 und Fig. 5 ist das weitere Ausführungsbeispiel entsprechend Fig. 3 in zwei verschiedenen Betriebsstellungen dargestellt, wobei auch hier vergleichbare Bauteile mit identischen Bezugszeichen versehen sind, so dass eine detaillierte Erläuterung dieser Bauteile überflüssig ist. In der in Fig. 4 dargestellten Betriebsstellung ist der Wagen 6 entlang des Transportwegs 4 mit einer Hebeeinrichtung 7 über einem auszubauenden Kammerdeckel 10 positioniert. Die Positionierung ist dabei so ausgerichtet, dass entsprechende Greifer 15 der Hebeeinrichtung 7 vertikal über entsprechenden Eingriffsmitteln (nicht gezeigt) des Kammerdeckels 10 angeordnet sind. Nach Abschluss der Positionierung können die Greifer 15 der Hebeeinrichtung 7 nun mit den Eingriffsmitteln des Kammerdeckels 10 in Eingriff gebracht und der Kammerdeckel 10 von der Kammer abgehoben werden.

Wie in Fig. 5 dargestellt, wird der Kammerdeckel 10 durch die Hebeeinrichtung 7 in eine vertikale Position befördert, in der der Kammerdeckel 10 sich mit seiner Unterseite in Bezug auf die Kammer oberhalb von dieser befindet. Wie in Fig. 4 und 5 dargestellt, kann der Kammerdeckel 10 mit Verbindungsrohrleitungen 16 für den Anschluss von Vorpumpen versehen sein. Der abgehobene Kammerdeckel 10 gibt in Fig. 5 den Blick frei auf eine dahinter liegende Pumpstufe 17, die ebenfalls solche Verbindungsrohrleitungen 16 aufweist. Nun kann der Kammerdeckel 10 durch Verfahren des Wagens 6 entlang des Transportwegs 4 von der Kammer wegbefördert und in einem Ablage-/Aufnahmebereich z. B. oberhalb des Schleusenbereichs 3 abgelegt werden.

Wahlweise ist es natürlich auch möglich, zur Zeitersparnis an dem Wagen 6 weitere Hebeeinrichtungen 7 vorzusehen, die vor Abnahme des Kammerdeckels 10 mit einem oder mehreren anderen Kammerdeckeln 10 bestückt werden. Dann könnte einer dieser Ersatzkammerdeckel 10 über der durch Abnahme des Kammerdeckels 10 freigewordenen Kammerdeckelöffnung positioniert und die Kammerdeckelöffnung mit dem Ersatzkammerdeckel 10 durch Absenkung desselben verschlossen werden. Auf diese Weise kann der Austausch von Kammerdeckeln noch effizienter ausgeführt werden.

Diese eben beschriebenen Vorgänge könnten vollautomatisch mittels geeigneter Positionierungssysteme gesteuert werden, es ist jedoch auch denkbar, dass der Wagen 6 durch Bedienpersonal auf dem Standbereich 14 begleitet wird und das Bedienpersonal die Steuerung übernimmt. Alternativ könnte die Steuerung auch von Bedienpersonal auf der Plattform 13 oder von anderswo gesteuert und überwacht werden.

## Patentansprüche

1. Vorrichtung zum Austausch und Transport von Komponenten von Beschichtungsanlagen (1), insbesondere Kammerdeckeln von Glasbeschichtungsanlagen, mit einem Transportsystem aus Transportweg (4) und mindestens einem entlang des Transportwegs verfahrbaren Wagen (6), an dem mindestens eine Hebeeinrichtung (7) zum Aufnehmen der auszutauschenden Komponenten (10) vorgesehen ist,
**dadurch gekennzeichnet, dass**
der Transportweg (4) Führungsorgane aufweist, die einen genau vorgegebenen, der Beschichtungsanlage (1) zugeordneten Transportweg definieren, wobei der Transportweg entlang der Beschichtungsanlage so angeordnet ist, dass der entlang des Transportwegs verfahrbare Wagen (6) mit der Hebeeinrichtung (7) diese zwangsgeführt genau in die für die zu tauschenden Komponenten (10) richtigen Hebe- und Absetzpositionen bringt.

2. Vorrichtung nach Anspruch 1,
**dadurch gekennzeichnet, dass**
das Transportsystem auf der Beschichtungsanlage (1), benachbart zu dieser oder diese umgreifend oder über der Beschichtungsanlage anordenbar ist.

3. Vorrichtung nach Anspruch 1 oder 2,
**dadurch gekennzeichnet, dass**
die Führungsorgane durch Schienen (4), Zahnstangen, Rundführungen oder Magnetbahnen gebildet sind, die insbesondere auf der Beschichtungsanlage (1), neben dieser oder über dieser anordenbar sind.

4. Vorrichtung nach einem der vorhergehenden Ansprüche,
**dadurch gekennzeichnet, dass**
der Wagen (6) mehrere Hebeeinrichtungen (7) aufweist, insbesondere derart angeordnet, dass ein gleichzeitiger Austausch von Komponenten der Beschichtungsanlage möglich ist.

5. Vorrichtung nach einem der vorhergehenden Ansprüche,
**dadurch gekennzeichnet, dass**
mindestens ein Ablage- und/oder Aufnahmebereich (3) zur Bereitstellung und/oder Lagerung von Komponenten (10) der Beschichtungsanlage (1) vorgesehen ist.

6. Vorrichtung nach Anspruch 5,
**dadurch gekennzeichnet, dass**
der Wagen (6) genau so viele oder weniger Hebeeinrichtungen (7) umfasst, die dem Platzangebot eines Ablage- und/oder Aufnahmebereichs zur Bereitstellung und/oder Lagerung von Komponenten der Beschichtungsanlage entsprechen.

7. Vorrichtung nach einem der vorhergehenden Ansprüche,
**dadurch gekennzeichnet, dass**
zwei oder mehr Wagen (6) vorgesehen sind.

8. Vorrichtung nach einem der vorhergehenden Ansprüche,
**dadurch gekennzeichnet, dass**
der Wagen (6) als Portalkran oder durch ein Gestell aus zwei parallel zueinander angeordneten Trägern (9) gebildet ist, die auf Stützen (8) und/oder Bewegungsmitteln lagern und durch mindestens zwei Querträger (11) verbunden sind, wobei an oder zwischen den Trägern die Hebeeinrichtung(en) (7) angeordnet sind.

9. Vorrichtung nach Anspruch 8,
**dadurch gekennzeichnet, dass**
ein Träger (9) und die ihm zugeordneten Stützen (8) eine U- oder L-Form aufweisen.

10. Vorrichtung nach einem der vorhergehenden Ansprüche,
**dadurch gekennzeichnet, dass**
der verfahrbare Wagen (6) Räder, Rollen, Schlitten, Zahnräder oder Gleitelemente und/oder Antriebsmittel (5) für diese aufweist.

11. Vorrichtung nach einem der vorhergehenden Ansprüche,
**dadurch gekennzeichnet, dass**
eine programmtechnisch eingerichtete Datenverarbeitungsanlage zur Steuerung der Vorrichtung vorgesehen ist, die in Zusammenarbeit mit Sensormitteln am Wagen und/oder Transportweg einen insbesondere vollautomatischen oder halbautomatischen Austausch von Komponenten durch insbesondere automatische Positionierung des Wagens an der auszutauschenden Komponente nach entsprechender Eingabe durch den Benutzer ermöglicht.

12. Beschichtungsanlage, insbesondere Vakuumbeschichtungsanlage zur kontinuierlichen Beschichtung von großformatigen, scheiben- oder plattenförmigen Substraten, vorzugsweise Glasbeschichtungsanlage
**gekennzeichnet durch**
eine Vorrichtung zum Austausch und Transport von Komponenten nach einem der vorhergehenden Ansprüche.

13. Beschichtungsanlage nach Anspruch 12,
**dadurch gekennzeichnet, dass**
die zu entnehmenden Komponenten (10) der Beschichtungsanlage, insbesondere die Kammerdeckel und vorzugsweise daran angeordnete Kathoden und Pumpen Mittel zum Eingreifen der Hebeeinrichtung(en) (7) derart umfassen, dass Hebeeinrichtung und Mittel zum Eingreifen der Hebeeinrichtung (7) so aufeinander abgestimmt sind, dass ein automatisches, insbesondere ferngesteuertes Ineinandergreifen und Lösen möglich sind.

14. Beschichtungsanlage nach einem der Ansprüche 12 oder 13,
**dadurch gekennzeichnet, dass**
die Beschichtungsanlage (1) einen Einschleusbereich (3), einen Ausschleusbereich und/oder einen Pufferbereich aufweist, wobei einer oder mehrere dieser Bereiche als Ablage- und/oder Aufnahmebereich für Komponenten der Beschichtungsanlage ausgestaltet sind.

15. Beschichtungsanlage nach einem der Ansprüche 12 bis 14,
**dadurch gekennzeichnet, dass**
sich der Transportweg (4) über die gesamte Beschichtungsanlage (1), insbesondere auch über den oder die Ablage- und/oder Aufnahmebereiche erstreckt.

16. Beschichtungsanlage nach Anspruch 13 oder Vorrichtung nach einem der Ansprüche 1 bis 11,
**dadurch gekennzeichnet, dass**
die Hebeeinrichtung form- und/oder kraftschlüssige Greifeinrichtungen aufweist.

17. Beschichtungsanlage nach Anspruch 13 oder Vorrichtung nach einem der Ansprüche 1 bis 11,
**dadurch gekennzeichnet, dass**
die Hebeeinrichtung eine Haltesicherung für die Komponenten insbesondere gegen Verrutschen während des Transports, Hebens oder Absenkens aufweist.
